# EUROPÄISCHE PATENTANMELDUNG

(11) **EP 1 729 346 A1**
(43) Veröffentlichungstag der Anmeldung: **06.12.2006**
(21) Anmeldenummer: 05011772.0
(22) Anmeldetag: 01.06.2005
(51) Int. Cl.: H01L 27/32, H01L 51/52

(54) **Lichtemittierendes Bauteil mit einer Elektrodenanordnung**

(71) Anmelder: Novaled AG, 01307 Dresden (DE)
(72) Erfinder: Birnstock, Jan, Dr., 01187 Dresden (DE); Murano, Sven, Dr., 01099 Dresden (DE)
(74) Vertreter: Bittner, Thomas L.

(57) **Zusammenfassung**

Die Erfindung betrifft ein lichtemittierendes Bauteil mit einer Elektrodenanordnung zum Anlegen einer elektrischen Spannung an mehrere organische Bereichen, die über eine Bauteilfläche (5) verteilt sind und beim Anlegen der elektrischen Spannung jeweils Licht emittieren, wobei die mehreren organischen Bereiche zwischen einer flächig gebildeten Elektrode und einer flächig gebildeten Gegenelektrode der Elektrodenanordnung angeordnet sind und wobei die Elektrode eine Teilelektrode (1) mit voneinander beabstandeten Elektrodenabschnitten (7) und eine weitere, von der Teilelektrode (1) elektrisch isolierte Teilelektrode (2) mit voneinander beabstandeten Elektrodenabschnitten (8) aufweist; die Elektrodenabschnitte (7) der Teilelektrode (1) und die Elektrodenabschnitte (8) der weiteren Teilelektrode (2) an einem jeweiligen Verbindungsabschnitt (10; 11) der Teilelektrode (1) / der weiteren Teilelektrode (2) gebildet sind; die Elektrodenabschnitte (7) der Teilelektrode (1) mit ersten organischen Bereichen, die jeweils Licht einer ersten Farbe emittieren, und die Elektrodenabschnitte (8) der weiteren Teilelektrode (2) mit zweiten organischen Bereichen verbunden sind, die jeweils Licht einer zweiten Farbe emittieren; und die Teilelektrode (1) und die weitere Teilelektrode (2) der flächig gebildeten Elektrode in Blickrichtung auf die Bauteilfläche (5) einander nicht überlappend gebildet sind.

## Beschreibung

Die Erfindung betrifft ein lichtemittierendes Bauteil mit einer Elektrodenanordnung zum Anlegen einer elektrischen Spannung an mehrere organische Bereiche, die über eine Bauteilfläche verteilt sind und beim Anlegen der elektrischen Spannung jeweils Licht unterschiedlicher Farbe emittieren, wobei die mehreren organischen lichtemittierenden Bereiche zwischen einer flächig gebildeten Elektrode und einer flächig gebildeten Gegenelektrode der Elektrodenanordnung angeordnet sind.

### Stand der Technik

In dem Dokument DE 101 45 492 A1 wird ein lichtemittierendes Bauelement mit einem lichtemittierenden organischen Bereich beschrieben, welches mittels voneinander separierter OLED-Substrukturen (OLED - organische lichtemittierende Diode), beispielsweise in Form von flächig gebildeten Punkten oder Streifen, die Licht unterschiedlicher Wellenlänge emittieren, sowie mittels eines sich anschließenden Streuelementes Weißlicht erzeugt. Die OLED-Substrukturen werden hierbei mit Hilfe separater Elektroden kontaktiert und mittels einer Spannungsquelle angesteuert, wodurch eine optimierte Mischung der unterschiedlichen Farben erzielt werden kann.

Ein Verfahren zum Herstellen eines solchen lichtemittierenden Bauelementes erfordert notwendigerweise Verfahrensschritte, beispielsweise Maskierungsschritte, um eine Abscheidung von unterschiedlichen Materialien auf den Substrukturen des Substrates zu ermöglichen. Darüber hinaus ist gegebenenfalls die Struktur des Substrates komplexer als dies bei gewöhnlichen weißen OLEDs der Fall ist, welche direkt Weißlicht emittieren. Trotzdem bietet der Ansatz zur Erzeugung von Weißlicht auf Basis von Mischung des Lichtes, welches von den Substrukturen abgestrahlt wird, die Licht unterschiedlicher Wellenlängen emittieren, einen bedeutenden Vorteil, nämlich die Möglichkeit zum Einstellen einer Gesamtmischfarbe für das emittierte Licht mittels einer gezielten Variation der Versorgungsspannung oder des Versorgungsstromes der OLED-Substrukturen.

Falls beispielsweise Weißlicht mittels Verwendung von roten, grünen und blauen OLED-Substrukturen erzeugt wird, sind grundsätzlich alle Farbkoordinaten erreichbar, welche sich innerhalb des Dreieckes befinden, das im CIE-Farbdiagramm von den einzelnen Farben aufgespannt wird. Im Falle der Mischung des Lichtes von zwei unterschiedlichen OLED-Substrukturen, beispielsweise von Substrukturen, die gelbes und blaues Licht emittieren, sind alle Punkte zugänglich, welche sich auf einer Linie zwischen den beiden individuellen Farbpunkten befinden. Eine solche Grade verläuft idealerweise weitgehend parallel zur Kurve eines schwarzen Strahlers, wodurch sich die Einstellung der Farbtemperatur über einen weiten Bereich erzielen lässt. Eine solche Möglichkeit ist besonders erstrebenswert für Anwendungen im Bereich der Beleuchtungstechnik, da es so dem Nutzer ermöglicht wird, die Lichtquelle individuell nach seinen Wünschen zu regeln.

Ein Nachteil für eine solche OLED-basierte Weißlichterzeugung ist jedoch, dass die Verwendung von OLED-Substrukturen erhöhte Produktionskosten im Vergleich zu anderen OLED-Beleuchtungskonzepten zu Folge hat, welche beim Herstellen des OLED-Beleuchtungsbauteils ohne zusätzliche Strukturierung auskommen. Dieses ist nachteilig im Hinblick auf eine kommerzielle Anwendung solcher Beleuchtungsbauteile.

Neben den bereits erwähnten Kosten für die zusätzliche Strukturierung des Substrates bzw. die zusätzlichen Prozessschritte ist es weiterhin erforderlich, die einzelnen Farben und somit die entsprechenden Substrukturen individuell zu adressieren. Der Stand der Technik sieht in diesem Zusammenhang vor, dass eine der zur Ansteuerung in OLED-Bauteilen genutzten Elektroden strukturiert wird, beispielsweise in Form transparenter ITO-Streifen, welche dann individuell an einen Treiber angeschlossen werden, ähnlich wie dies Passivmatrix-Anzeigeelementen der Fall ist. Ein solcher Ansatz erfordert bei der Herstellung jedoch einen Verbindungsschritt zum Bonden, beispielsweise mittels einer Verklebung. Dies erfolgt üblicherweise mit hoher Präzision, beispielsweise unter Ausrichtung mittels eines Mikroskops. Darüber hinaus werden für die Verklebung üblicherweise erhöhte Temperaturen benötigt.

In den Dokumenten DE 199 16 745 A1 und DE 101 45 492 A1 wird deshalb vorgeschlagen, für die in Form von Streifen gebildeten OLED-Substrukturen des selben Typs, die Licht gleicher Wellenlänge emittieren, einen gemeinsamen Anschluss zu verwenden, während unterschiedliche Streifentypen getrennt angeschlossen werden. Hierbei kann vorgesehen sein, dass die zur Ansteuerung genutzten Elektroden der Streifenstruktur der OLED-Substrukturen entsprechend strukturiert sind.

Auch in dem Dokument US 2002/0084993 A1 ist ein organisches lichtemittierendes Bauteil beschrieben, bei dem streifenförmige organische Bereiche, die zwischen zwei Elektroden angeordnet sind, mit streifenförmigen Elektrodenabschnitten verbunden sind, über die eine elektrische Spannung zur Ansteuerung der organischen Bereiche angelegt wird. Zueinander benachbarte streifenförmige Elektrodenabschnitte werden mit unterschiedlichen Spannungen beaufschlagt, um den jeweils zugehörigen organischen Bereich anzusteuern.

### Die Erfindung

Der Erfindung liegt die Aufgabe zugrunde, ein lichtemittierendes Bauteil mit einer Elektrodenanordnung zum Ansteuern von mehreren organischen Bereichen, die beim Anlegen einer elektrischen Spannung an die Elektrodenanordnung jeweils Licht emittieren, zu schaffen, wobei die Elektrodenanordnung mit möglichst wenig Verfahrensschritten und platzsparend herstellbar sein soll.

Diese Aufgabe wird erfindungsgemäß durch ein lichtemittierendes Bauteil nach den unabhängigen Ansprüchen 1 und 15 gelöst. Vorteilhafte Ausgestaltungen der Erfindung sind Gegenstand von abhängigen Unteransprüchen.

Nach einem Aspekt der Erfindung ist ein lichtemittierendes Bauteil mit einer Elektrodenanordnung zum Anlegen einer elektrischen Spannung an mehrere organische Bereichen geschaffen, die über eine Bauteilfläche verteilt sind und beim Anlegen der elektrischen Spannung jeweils Licht emittieren, wobei die mehreren organischen Bereiche zwischen einer flächig gebildeten Elektrode und einer flächig gebildeten Gegenelektrode der Elektrodenanordnung angeordnet sind. Hierbei ist vorgesehen, dass die Elektrode eine Teilelektrode mit voneinander beabstandeten Elektrodenabschnitten und eine weitere, von der Teilelektrode elektrisch isolierte Teilelektrode mit voneinander beabstandeten Elektrodenabschnitten aufweist; die Elektrodenabschnitte der Teilelektrode und die Elektrodenabschnitte der weiteren Teilelektrode an einem jeweiligen Verbindungsabschnitt der Teilelektrode / der weiteren Teilelektrode gebildet sind; die Elektrodenabschnitte der Teilelektrode mit ersten organischen Bereichen, die jeweils Licht einer ersten Farbe emittieren, und die Elektrodenabschnitte der weiteren Teilelektrode mit zweiten organischen Bereichen verbunden sind, die jeweils Licht einer zweiten Farbe emittieren; und die Teilelektrode und die weitere Teilelektrode der flächig gebildeten Elektrode in Blickrichtung auf die Bauteilfläche einander nicht überlappend gebildet sind.

Nach einem weiteren Aspekt der Erfindung ist ein lichtemittierendes Bauteil mit einer Elektrodenanordnung zum Anlegen einer elektrischen Spannung an mehrere organische Bereiche geschaffen, die zwischen einer flächig gebildeten Elektrode und einer flächig gebildeten Gegenelektrode der Elektrodenanordnung angeordnet sind und beim Anlegen der elektrischen Spannung jeweils Licht emittieren, wobei eine Anordnung mehrerer Reihenschaltungen lichtemittierender organischer Bauelemente gebildet ist, indem
- die Elektrode in Form mehrerer Streifensegmente gebildet ist, die benachbart zueinander angeordnet sind, und die Gegenelektrode segmentiert ist;
- die mehreren organischen Bereiche jeweils mit einem der mehreren Streifensegmente der Elektrode verbunden sind; und
- mit Hilfe der segmentierten Gegenelektrode jeder der organischen Bereiche mit einem benachbarten Streifensegment, welches benachbart zu dem einen der mehreren Streifensegmente angeordnet ist, verbunden ist, so dass ein Teil der mehreren organischen Bereiche mit einem auf einer Seite benachbarten Streifensegment und ein anderer Teil der organischen Bereiche mit einem auf einer gegenüberliegenden Seite benachbarten Streifensegment verbunden ist.

Ein wesentlicher Vorteil, der mit der Erfindung gegenüber dem Stand der Technik erreicht wird, besteht darin, dass die Herstellung von Bauteilen mit organischen lichtemittierenden Substrukturen zum Erzeugen von Licht unterschiedlicher Farben wesentlich vereinfacht wird. Darüber hinaus kann die Ausbeute erhöht werden. Diese Vorteile führen zu einer Verminderung der Herstellungskosten. Des weiteren wird die elektrische Kontaktierung vereinfacht. Prozessschritte können entfallen, wodurch Kosten eingespart werden

### Ausführungsbeispiele der Erfindung

Die Erfindung wird im folgenden anhand von Ausführungsbeispielen unter Bezugnahme auf Figuren der Zeichnung näher erläutert. Hierbei zeigen:
- Fig. 1: eine schematische Darstellung einer Elektrode für ein lichtemittierendes Bauteil mit mehreren organischen Bereichen, die über eine Bauteilfläche verteilt sind und beim Anlegen einer elektrischen Spannung über die Elektrodenanordnung Licht in zwei unterschiedlichen Farben emittieren, wobei Teilelektroden der Elektrode in Blickrichtung auf die Bauteilfläche nicht überlappend gebildet sind;
- Fig. 2: eine schematische Darstellung einer Elektrode für ein lichtemittierendes Bauteil mit mehreren organischen Bereichen, die über eine Bauteilfläche verteilt sind und beim Anlegen einer elektrischen Spannung über die Elektrodenanordnung Licht in drei unterschiedlichen Farben emittieren, wobei drei Teilelektroden gebildet sind;
- Fig. 3: eine schematische Darstellung einer Anordnung von mehreren organischen Bereichen für ein lichtemittierendes Bauteil;
- Fig. 4: eine schematische Darstellung der Anordnung von mehreren organischen Bereichen nach Fig. 3, wobei eine untere Elektrode mit zwei nicht überlappenden Teilelektroden gebildet ist;
- Fig. 5: eine schematische Darstellung der Anordnung von mehreren organischen Bereichen nach Fig. 3, wobei eine obere Elektrode mit zwei nicht überlappenden Teilelektroden gebildet ist; und
- Fig. 6: eine schematische Darstellung einer Elektrodenanordnung und mehrerer organischer Bereiche für ein lichtemittierendes Bauteil, wobei eine Anordnung mit mehreren Reihenschaltungen organischer lichtemittierender Bauelemente gebildet ist.

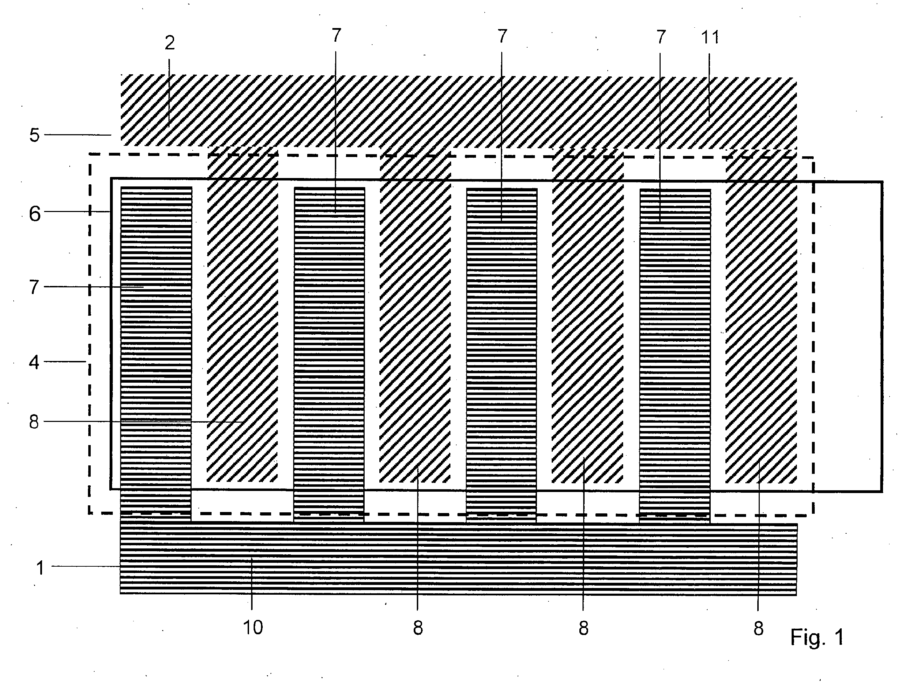

Fig. 1 zeigt eine schematische Darstellung einer Elektrode für ein lichtemittierendes Bauteil, bei dem über die Elektrode lichtemittierende organische Bereiche angesteuert werden, indem eine elektrische Spannung angelegt wird. Die Elektrode umfasst zwei flächige gebildete Teilelektroden 1, 2, welche in nebeneinander angeordneten Schichten gebildet sind. Oberhalb der beiden Teilelektroden 1, 2 ist eine lichtemittierende Schicht 4 gebildet, die über mehrere organische Bereiche verfügt, die ihrerseits über eine Bauteilfläche 5 verteilt sind und beim Anlegen einer elektrischen Spannung Licht emittieren. Die lichtemittierende Schicht umfasst Ausführung zwei unterschiedlich aufgebaute organische Bereiche, die jeweils Licht einer bestimmten Farbe emittieren. Oberhalb der lichtemittierenden Schicht 4 ist eine flächig ausgebildete Gegenelektrode 6 angeordnet.

Mittels Anlegen einer elektrischen Spannung an die Elektrode, die die Teilelektroden 1, 2 umfasst, und die Gegenelektrode 6 werden die mehreren organischen Bereiche in dem lichtemittierenden Bereich 4 mit einer jeweiligen elektrischen Spannung beaufschlagt, so dass Licht emittiert wird. Es sind zwei unterschiedliche organische Bereiche gebildet, die sich hinsichtlich ihrer Materialzusammensetzung unterscheiden, so dass sie Licht mit unterschiedlichen Farben emittieren.

An den beiden Teilelektroden 1, 2 sind jeweils Elektrodenabschnitte 7, 8 vorgesehen, die an einem von der jeweiligen Teilelektrode 1, 2 umfassten Verbindungsabschnitt 10, 11 gebildet und in Blickrichtung auf die Bauteilfläche 5 auf Lücke versetzt zueinander angeordnet sind. Die Elektrodenabschnitte 7 der Teilelektrode 1 sind mit einer Art organischer Bereiche verbunden, welche Licht mit einer ersten Farbe emittieren. Die Elektrodenabschnitte 8 der Teilelektrode 2 sind mit einer anderen Art organischer Bereiche verbunden, die Licht mit einer zweiten Farbe emittieren. Gemäß Fig. 1 überlappen sich die Teilelektroden 1, 2 in Blickrichtung auf die Bauteilfläche 5 nicht.

Die beiden Teilelektroden 1, 2 sind gemäß Fig. 1 in Blickrichtung auf die Bauteilfläche 5 nicht überlappend gebildet. Dieses ermöglicht es, die Teilelektroden 1, 2 bei der Herstellung wahlweise in zwei getrennten Schichten oder in einer gemeinsamen Schicht auszubilden. Bei den kammförmig gebildeten Teilelektroden 1, 2 greifen die Elektrodenabschnitte 7, 8 gegenseitig ineinander. Auf diese Weise wird die platzsparende Ausbildung der Teilelektroden 1, 2 unterstützt. Über die Teilelektroden 1, 2 können die organischen Bereiche unterschiedlicher Art zum Emittieren des Lichts separat angesteuert werden.

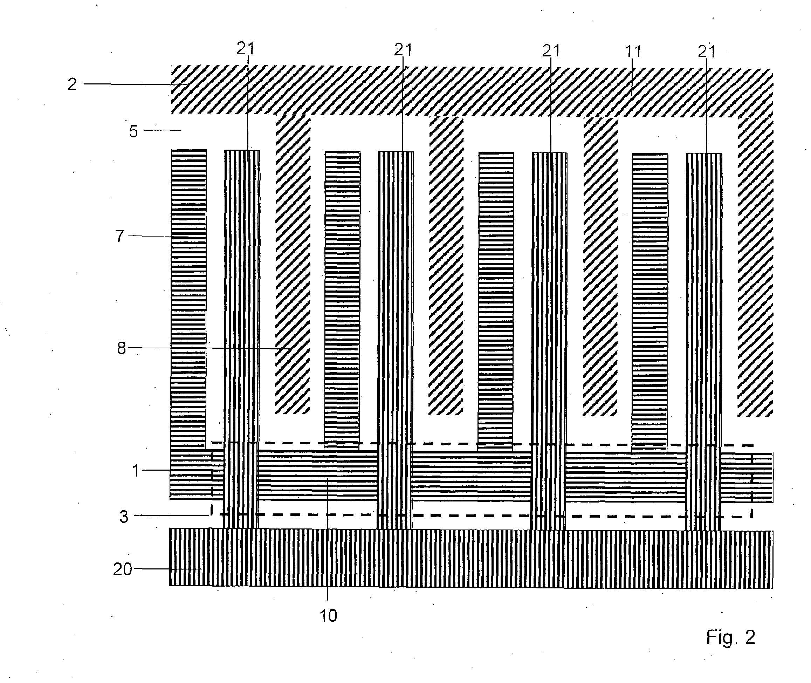

Fig. 2 zeigt eine schematische Darstellung einer Elektrode für ein lichtemittierendes Bauteil in einer weiteren Ausführungsform. In Fig. 2 werden für gleiche Merkmale die gleichen Bezugszeichen wie in den Fig. 1 verwendet. Neben den Teilelektroden 1, 2 ist eine weitere flächig gebildete Teilelektrode 20 vorgesehen, die mittels einer Isolationsschicht 3 von der Teilelektrode 1 getrennt ist. Die Elektrodenabschnitte 21 der weiteren Teilelektrode 20 sind an einem Verbindungsabschnitt 22 gebildet und in Blickrichtung auf die Bauteilfläche 5 auf Lücke versetzt mit den Elektrodenabschnitten 7, 8 der Teilelektroden 1, 2 und nicht überlappend mit diesen angeordnet. Auf diese Weise ist es ermöglicht, mit den Elektrodenabschnitten 7, 8, 21 insgesamt drei verschiedene Arten von organischen Bereichen getrennt anzusteuern, die jeweils Licht mit einer anderen Farbe emittieren.

Die Elektrodenabschnitte 7, 8, 21 sind jeweils streifenförmig gebildet. Die Grundfläche der Elektrodenabschnitte 7, 8, 21 überlappt jeweils im wesentlichen mit der Fläche des zugehörigen organischen Bereiches, der oberhalb des jeweiligen Elektrodenabschnitts gebildet ist (nicht dargestellt). Bei den drei verschiedenen Arten von organischen Bereichen kann es sich beispielsweise um organische Bereiche handeln, die rotes, grünes und blaues Licht emittieren. Auf diese Weise ist es ermöglicht, Weißlicht zu erzeugen. Bei dieser Ausführung besteht darüber hinaus die Möglichkeit, nur jeweils eine Elektrode, beispielsweise die obere, zu strukturieren.

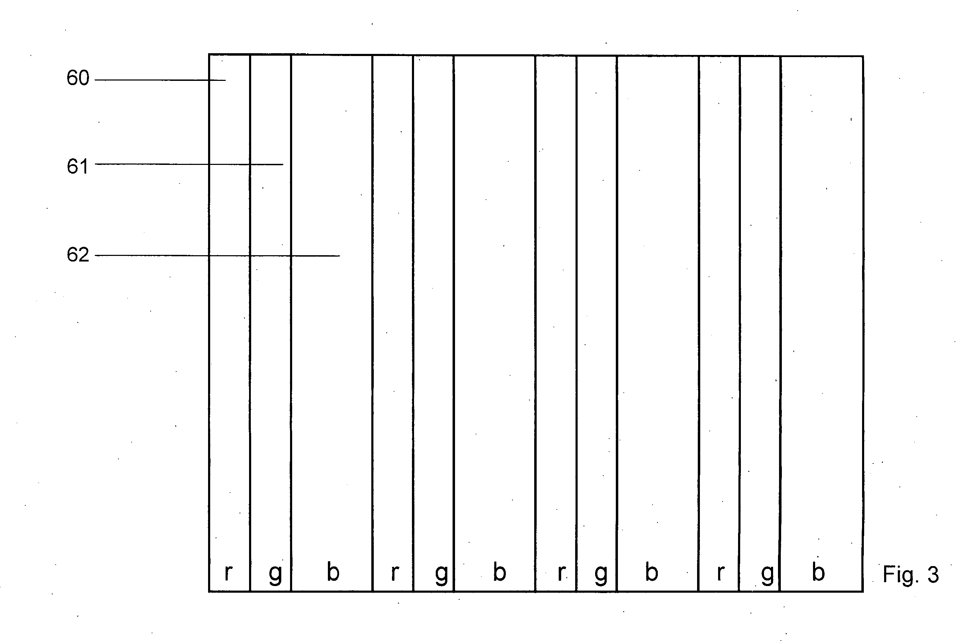

Es besteht alternativ die Möglichkeit, bei einem lichtemittierenden Bauteil, welches über streifenförmige organische Bereiche von drei verschiedenen Arten verfügt, die Isolationsschicht 3 einzusparen. Eine solche Ausführungsform ist in den Fig. 3 bis 5 dargestellt. Fig. 3 zeigt eine schematische Darstellung einer Anordnung von drei organischen Bereichen 60, 61, 62. Hierbei handelt es sich um organische Bereiche, die rotes, grünes und blaues Licht emittieren.

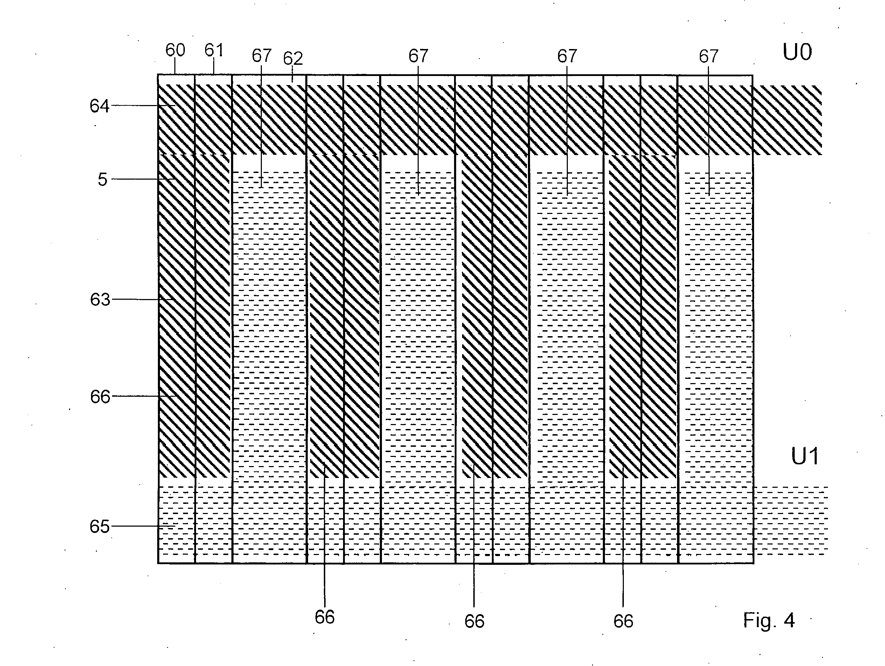

Als flächig gebildete untere Elektrode 63 ist gemäß Fig. 4 eine Anordnung von zwei unteren Teilelektroden 64, 65 gebildet, bei der streifenförmig ausgeführte Elektrodenabschnitte 66, 67 in Blickrichtung auf die Bauteilfläche 5 auf Lücke versetzt und ineinandergreifend angeordnet sind. Hierbei ist vorgesehen, dass die Elektrodenabschnitte 66 der unteren Teilelektrode 64 sich über zwei organische Bereiche 60, 61 erstrecken und mit diesen elektrisch verbunden sind, wobei sich eine Grundfläche der Elektrodenabschnitte 66 mit den Grundfläche der organischen Bereiche 60, 61 zumindest in Teilbereichen überlappt. An die unteren Teilelektroden 64, 65 werden gemäß Fig. 4 Betriebsspannungen U0 und U1 angelegt.

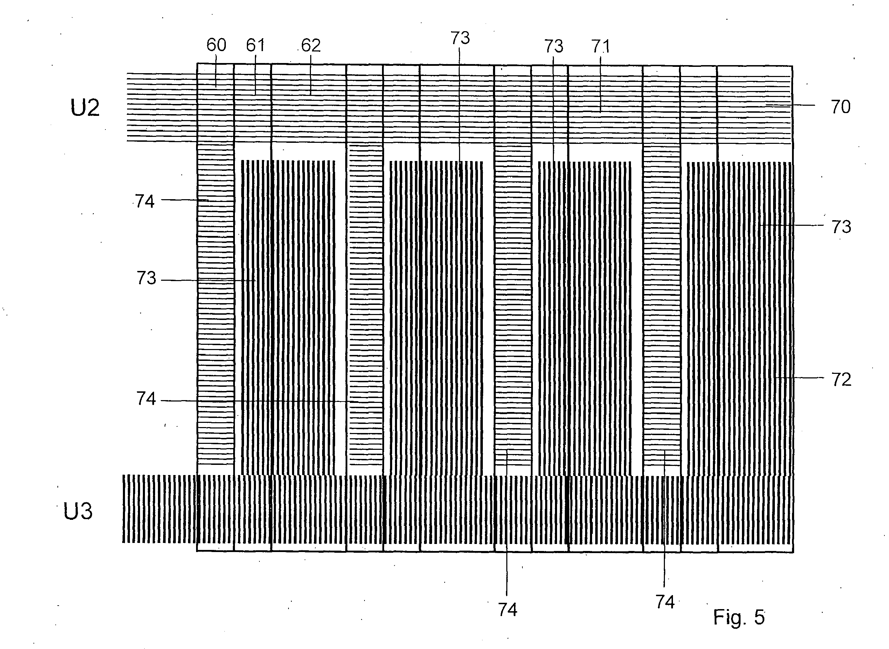

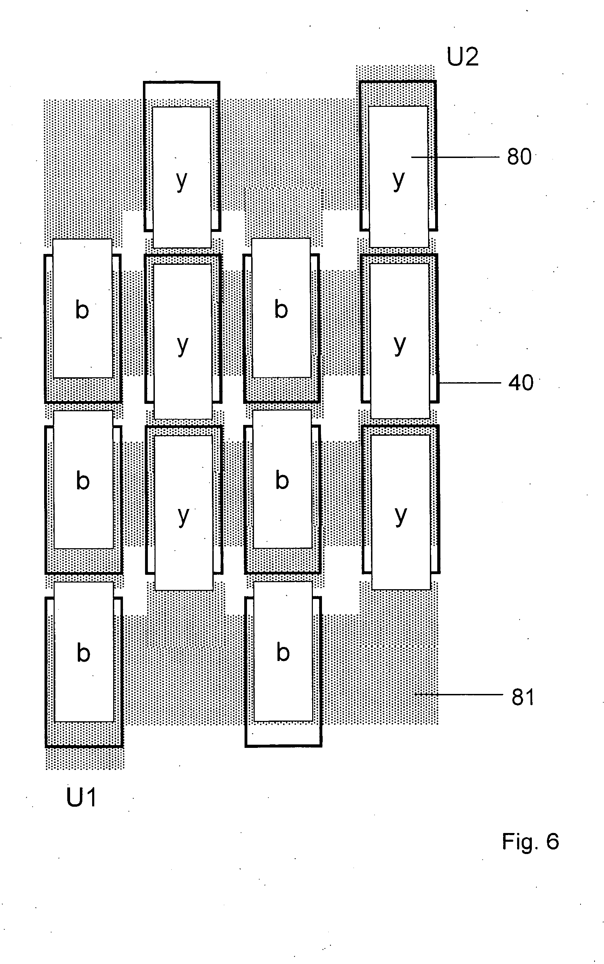

Fig. 5 zeigt eine schematische Darstellung der Anordnung von mehreren organischen Bereichen nach Fig. 3, wobei eine flächig gebildete obere Elektrode 70 mit zwei nicht überlappenden oberen Teilelektroden 71, 72 gebildet ist. Elektrodenabschnitte 73 der oberen Teilelektrode 72 sind mit den zwei organischen Bereichen 61, 62 verbunden, wohingegen streifenförmig ausgebildete Elektrodenabschnitte 74 der oberen Teilelektrode 71 mit den organischen Bereichen 60 elektrisch verbunden sind. Betriebsspannungen U2 und U3 werden gemäß Fig. 6 an die oberen Teilelektroden 71, 72 angelegt.

Mit Hilfe der Elektrodengestaltung nach den Fig. 4 und 5 wird bei der Anordnung organischer Bereiche gemäß Fig. 3 erreicht, dass an alle organischen Bereiche gleicher Art die selbe Spannung angelegt wird, während sich die Betriebsspannungen für die drei unterschiedlichen Arten von organischen Bereichen unterscheiden. An allen organischen Bereichen 60 liegt eine Betriebsspannung U0 - U2 an. Demgegenüber werden alle organischen Bereiche 62 mit einer Betriebsspannung U1 - U3 versorgt. Schließlich liegt an den organischen Bereichen 61 eine Betriebsspannung von U0 - U3 an.

Unter Verwendung des gleichen Konstruktionsprinzips, wie es in Verbindung mit den Fig. 3 bis 5 erläutert wurde, kann auch eine Elektrodenanordnung zur Spannungsversorgung eines lichtemittierenden Bereiches mit vier verschiedenen Arten von organischen Bereichen gebildet werden, ohne dass es einer Isolationsschicht im Bereich der oberen und / oder der unteren Elektrode zur Isolation von Teilelektroden bedarf. Bei einer solchen Ausführungsform ist dann jeder Elektrodenabschnitt der Teilelektroden in der oberen und der unteren Elektrode jeweils mit zwei unterschiedlichen Arten von organischen Bereichen elektrisch verbunden. Zur Versorgung der unterschiedlichen organischen Bereiche mit unterschiedlichen Betriebsspannungen, wobei an organischen Bereichen gleicher Art die selbe Betriebsspannung anliegt, können beispielsweise die folgenden Betriebsspannungen verwendet werden: U0 - U2, U0 - U3, U1 - U2 und U1 - U3. Alle vier Betriebsspannungen können frei und unabhängig voneinander gewählt werden.

In den Ausführungsbeispielen in den Fig. 1 bis 5 sind die anzusteuernden organischen Bereiche streifenförmig gebildet. Die zugehörigen Elektrodenabschnitte sind deshalb ebenfalls in Form von Streifen gebildet. Die erläuterten Konstrulctionsprinzipien für die Ausbildung der flächigen Elektroden lassen sich jedoch auf lichtemittierende Bauteile mit in anderer Weise geformten organischen Bereichen übertragen, zum Beispiel bei organischen Bereichen, die eine runde Grundfläche aufweisen oder als Zick-Zack-Linien gebildet sind. Mit Hilfe der Erfindung ist auch bei solchen Bauteilen eine mit geringem Aufwand herstellbare und platzsparend ausgeführte Elektrodenanordnung ausbildbar.

Fig. 6 zeigt eine schematische Darstellung einer Elektrodenanordnung und mehrerer organischer Bereiche für ein lichtemittierendes Bauteil, wobei eine Anordnung mit mehreren Reihenschaltungen organischer lichtemittierender Bauelemente gebildet ist. Selbst eine solche komplizierte Anordnung lässt sich unter Verwendung der oben beschriebenen Konstruktionsprinzipien für die Elektrodenanordnung ohne zusätzliches Aufbringen einer Isolationsschicht zum Isolieren von Teilelektroden realisieren. In Fig. 6 sind zwei unterschiedliche Arten von organischen Bereichen "b" und "y" vorgesehen, die Licht mit zwei unterschiedlichen Farben emittieren. Es sind eine obere Elektrode 80 und eine untere Elektrode 81 gebildet, zwischen denen die organischen lichtemittierenden Bereiche angeordnet sind. Es werden die beiden Spannungen U1 und U2 angelegt.

Die untere Elektrode 81 ist in streifenförmige Segmente aufgeteilt, die nicht elektrisch verbunden sind. OLED-Segmente 40 sind aufgeteilt in die organischen Bereiche "b" und "y", welche Licht unterschiedlicher Farbe emittieren. Die obere Elektrode 80 umfasst Segmente, welche versetzt zu den OLED-Segmenten 40 aufgebracht sind, was derart erfolgt, dass mittels Versatz eine Kontaktierung der oberen Elektrode 80 mit einem benachbarten Streifen der unteren Elektrode 81 erfolgt. Hierbei kontaktiert die obere Elektrode 80 der organischen Bereiche "y" das in der Fig. 6 jeweils unterhalb angeordnete streifenförmige Segmant der unteren Elektrode 81, wohingegen die obere Elektrode 80 der organischen Bereiche "b" das in der Fig. 6 jeweils oberhalb angeordnete streifenförmige Segment der unteren Elektrode 81 kontaktiert. Hierdurch entsteht eine Reihenschalten der einzelnen organischen Bereiche, wobei die Polung für die lichtemittierenden organischen Bereiche "b" und "y", unter der Voraussetzung das diese die gleiche Ausrichtung hinsichtlich des bevorzugten Ladungstransportes der Dioden zum Substrat haben, für die angelegten Spannungen U1 und U2 jeweils gegensätzlich ist. Somit wird beim Anlegen einer Spannung U1, U2 jeweils entweder der organische Bereich "b" oder der organische Bereich "y" in Vorwärtsrichtung, nämlich in Betriebsrichtung mit einer Spannung versorgt, die andersfarbig emittierenden organischen Bereiche jedoch in Sperrrichtung. Bei einer Umkehr des Potentials werden entsprechend die jeweils anderen organischen Bereiche in Betriebsrichtung oder Sperrrichtung mit einer Spannung versorgt.

Es können Rechteckspannungsimpulse verwendet werden. In Vorwärtsrichtung leuchten dann nur die organischen Bereiche "b". In Rückwärtsrichtung leuchten die organischen Bereiche "y". Mittels Einstellen von Impulslänge und Impulshöhe der Rechteckspannungsimpulse lassen sich Helligkeit und Farbe durchstimmen. Mit Hilfe der Anordnung sind Reihenschaltungen lichtemittierender organischer Bauelemente geschaffen, so dass bei Ausfall eines leuchtenden Bereiches nicht das gesamte Bauteil ausfällt.

Die unter Bezugnahme auf Fig. 6 beschriebene Ausführungsform eines lichtemittierenden Bauteils ist, neben einer möglichen Verwendung in Kombination mit den Ausgestaltungen in den Fig. 1 bis 5, auch unabhängig hiervon als selbständiges Prinzip nutzbar. In sämtlichen Ausführungsformen sind Bauformen mit Elektrodenanordnungen geschaffen, die zum Ansteuern von organischen Bereichen dienen, die in der Lage sind, Licht unterschiedlicher Farben zu emittieren. Bei den lichtemittierenden Bauteilen sind sich überlappende Bereiche der vorgesehenen Elektroden, außer in Abschnitten, in denen eine elektrische Kontaktierung gewünscht ist, minimiert oder sogar vollständig vermieden.

Die in der vorstehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Lichtemittierendes Bauteil mit einer Elektrodenanordnung zum Anlegen einer elektrischen Spannung an mehrere organische Bereichen, die über eine Bauteilfläche (5) verteilt sind und beim Anlegen der elektrischen Spannung jeweils Licht emittieren, wobei:
- die mehreren organischen Bereiche zwischen einer flächig gebildeten Elektrode und einer flächig gebildeten Gegenelektrode der Elektrodenanordnung angeordnet sind;
- die Elektrode eine Teilelektrode (1; 64) mit voneinander beabstandeten Elektrodenabschnitten (7; 66) und eine weitere, von der Teilelektrode (1; 64) elektrisch isolierte Teilelektrode (2; 65) mit voneinander beabstandeten Elektrodenabschnitten (8; 67) aufweist;
- die Elektrodenabschnitte (7; 66) der Teilelektrode (1; 64) und die Elektrodenabschnitte (8; 67) der weiteren Teilelektrode (2; 65) an einem jeweiligen Verbindungsabschnitt (10; 11) der Teilelektrode (1; 64) / der weiteren Teilelektrode (2; 65) gebildet sind;
- die Elektrodenabschnitte (7; 66) der Teilelektrode (1; 64) mit ersten organischen Bereichen, die jeweils Licht einer ersten Farbe emittieren, und die Elektrodenabschnitte (8; 67) der weiteren Teilelektrode (2; 65) mit zweiten organischen Bereichen verbunden sind, die jeweils Licht einer zweiten Farbe emittieren; und
- die Teilelektrode (1; 64) und die weitere Teilelektrode (2; 65) der flächig gebildeten Elektrode in Blickrichtung auf die Bauteilfläche (5) einander nicht überlappend gebildet sind.

2. Lichtemittierendes Bauteil nach Anspruch 1, **dadurch gekennzeichnet, dass** die Elektrodenabschnitte (7; 66) der Teilelektrode (1; 64) und die Elektrodenabschnitte (8; 67) der weiteren Teilelektrode (2; 65) in Blickrichtung auf die Bauteilfläche (5) auf Lükke versetzt zueinander angeordnet sind.

3. Lichtemittierendes Bauteil nach Anspruch 1 oder 2, **dadurch gekennzeichnet, dass**
- die Elektrode eine andere Teilelektrode (20) mit voneinander beabstandeten Elektrodenabschnitten (21) aufweist, welche von der Teilelektrode (1) und der weiteren Teilelektrode (2) elektrisch getrennt ist;
- die Elektrodenabschnitte (21) der anderen Teilelektrode (20) an einem Verbindungsabschnitt (22) der anderen Teilelektrode (20) gebildet sind;
- die Elektrodenabschnitte (21) der anderen Teilelektrode (20) mit dritten organischen Bereichen verbunden sind, die jeweils Licht einer dritten Farbe emittieren; und
- die Elektrodenabschnitte (21) der anderen Teilelektrode (20) mit den Elektrodenabschnitten (7) der Teilelektrode (1) und mit den Elektrodenabschnitten (8) der weiteren Teilelektrode (2) in Blickrichtung auf die Bauteilfläche (5) jeweils auf Lücke versetzt und wahlweise nicht überlappend angeordnet sind.

4. Lichtemittierendes Bauteil nach einem der vorangehenden Ansprüche, **dadurch gekennzeichnet,dass**
- die Gegenelektrode eine Teilgegenelektrode (71) mit voneinander beabstandeten Elektrodenabschnitten (74) und eine weitere, von der Teilgegenelektrode (71) elektrisch getrennte Teilgegenelektrode (72) mit voneinander beabstandeten Elektrodenabschnitten (73) aufweist;
- die Elektrodenabschnitte (74) der Teilgegenelektrode (71) und die Elektrodenabschnitte (73) der weiteren Teilgegenelektrode (72) an einem jeweiligen Verbindungsabschnitt der Teilgegenelektrode (71) / der weiteren Teilgegenelektrode (72) gebildet sind;
- die Elektrodenabschnitte (74) der Teilgegenelektrode (71) mit den ersten organischen Bereichen und die Elektrodenabschnitte (73) der weiteren Teilgegenelektrode (72) mit den zweiten organischen Bereichen verbunden sind; und
- die Teilgegenelektrode (71) und die weitere Teilgegenelektrode (72) in Blickrichtung auf die Bauteilfläche (5) einander nicht überlappend gebildet sind.

5. Lichtemittierendes Bauteil nach Anspruch 4, **dadurch gekennzeichnet, dass** die Elektrodenabschnitte (74) der Teilgegenelektrode (71) und die Elektrodenabschnitte (73) der weiteren Teilgegenelektrode (72) in Blickrichtung auf die Bauteilfläche (5) auf Lücke versetzt zueinander angeordnet sind.

6. Lichtemittierendes Bauteil nach Anspruch 4 oder 5, **dadurch gekennzeichnet, dass**
- die Gegenelektrode eine andere Teilgegenelektrode mit voneinander beabstandeten Elektrodenabschnitten aufweist, welche von der Teilgegenelektrode und der weiteren Teilgegenelektrode elektrisch getrennt ist;
- die Elektrodenabschnitte der anderen Teilgegenelektrode mit dritten organischen Bereichen verbunden sind, die jeweils Licht einer dritten Farbe emittieren; und
- die Elektrodenabschnitte der anderen Teilgegenelektrode mit den Elektrodenabschnitten der Teilgegenelektrode und den Elektrodenabschnitten der weiteren Teilgegenelektrode in Blickrichtung auf die Bauteilfläche (5) jeweils auf Lücke versetzt und wahlweise nicht überlappend angeordnet sind.

7. Lichtemittierendes Bauteil nach einem der vorangehenden Ansprüche, **dadurch gekennzeichnet, dass**
- die Elektrodenabschnitte (66) der Teilelektrode (64) mit den ersten organischen Bereichen (60), die jeweils Licht der ersten Farbe emittieren, und mit ergänzenden organischen Bereichen (61) verbunden sind, die jeweils Licht einer ergänzenden Farbe emittieren, und
- die Elektrodenabschnitte (73) der weiteren Teilgegenelektrode (72) mit den zweiten organischen Bereichen (62), die jeweils Licht der zweiten Farbe emittieren, und mit den ergänzenden organischen Bereichen (61) verbunden sind.

8. Lichtemittierendes Bauteil nach einem der vorangehenden Ansprüche, **dadurch gekennzeichnet, dass** ein oder alle Elektrodenabschnitte (7; 8; 73; 74) als ein Streifen gebildet sind.

9. Lichtemittierendes Bauteil nach einem der vorangehenden Ansprüche, **dadurch gekennzeichnet, dass** die Elektrode und / oder die Gegenelektrode jeweils in einer einzigen Schicht gebildet sind.

10. Lichtemittierendes Bauteil nach einem der Ansprüche 1 bis 8, **dadurch gekennzeichnet, dass** die Elektrode und / oder die Gegenelektrode jeweils über mehrere Schichten verteilt gebildet sind.

11. Lichtemittierendes Bauteil nach einem der vorangehenden Ansprüche, **dadurch gekennzeichnet, dass** in einem Überlappungsbereich für einen oder alle Elektrodenabschnitte (73; 74) eine Grundfläche des Elektrodenabschnitts (73; 74) im wesentlichen einer Grundfläche eines zugehörigen organischen Bereiches (60; 61; 62) entspricht.

12. Lichtemittierendes Bauteil nach einem der vorangehenden Ansprüche, **dadurch gekennzeichnet, dass** die Elektrode mit kammförmigen Teilelektroden und / oder die Gegenelektrode mit kammförmigen Teilgegenelektroden gebildet ist.

13. Lichtemittierendes Bauteil nach Anspruch 12, **dadurch gekennzeichnet, dass** die kammförmigen Teilelektroden und / oder die kammförmigen Teilgegenelektroden mit ineinandergreifenden Elektrodenabschnitten (7, 8; 66, 67; 73, 74) angeordnet sind.

14. Lichtemittierendes Bauteil nach einem der vorangehenden Ansprüche, **dadurch gekennzeichnet, dass** die mehreren organischen Bereiche (60, 61, 62) in ihrer Summe Weißlicht emittierend gebildet sind.

15. Lichtemittierendes Bauteil mit einer Elektrodenanordnung zum Anlegen einer elektrischen Spannung an mehrere organische Bereiche (y; b), die zwischen einer flächig gebildeten Elektrode (81) und einer flächig gebildeten Gegenelektrode (80) der Elektrodenanordnung angeordnet sind und beim Anlegen der elektrischen Spannung jeweils Licht emittieren, wobei eine Anordnung mehrerer Reihenschaltungen lichtemittierender organischer Bauelemente gebildet ist, indem
- die Elektrode (81) in Form mehrerer Streifensegmente gebildet ist, die benachbart zueinander angeordnet sind, und die Gegenelektrode (80) segmentiert ist;
- die mehreren organischen Bereiche (y; b) jeweils mit einem der mehreren Streifensegmente der Elektrode (81) verbunden sind; und
- mit Hilfe der segmentierten Gegenelektrode (80) jeder der organischen Bereiche (y; b) mit einem benachbarten Streifensegment, welches benachbart zu dem einen der mehreren Streifensegmente angeordnet ist, verbunden ist, so dass ein Teil der mehreren organischen Bereiche (b) mit einem auf einer Seite benachbarten Streifensegment und ein anderer Teil der organischen Bereiche (y) mit einem auf einer gegenüberliegenden Seite benachbarten Streifensegment verbunden ist.

## Geänderte Patentansprüche

### Geänderte Patentansprüche gemäss Regel 86(2) EPÜ.

**1.** Lichtemittierendes Bauteil mit einer Elektrodenanordnung zum Anlegen einer elektrischen Spannung an mehrere organische Bereiche (60, 61, 62), die einen lichtemittierenden Bereich (4) bildend über eine Bauteilfläche (5) verteilt sind und beim Anlegen der elektrischen Spannung jeweils Licht emittieren, bei dem die mehreren organischen Bereiche (60, 61, 62) zwischen einer flächigen Elektrode (1, 2; 63) und einer flächigen Gegenelektrode (6; 70) angeordnet sind, **dadurch gekennzeichnet, dass** die Elektrode (1, 2; 63) aus einer Teilelektrode (1; 64) und einer weiteren Teilelektrode (2; 65) besteht, die von der Teilelektrode (1; 64) elektrisch isoliert und mit dieser ineinandergreifend gebildet ist, und dass die Elektrode (1, 2; 63) und die Gegenelektrode (6; 70) in Blickrichtung auf die Bauteilfläche (5) außerhalb des lichtemittierenden Bereiches (4) nicht überlappend gebildet sind.

**2.** Lichtemittierendes Bauteil nach Anspruch 1, **dadurch gekennzeichnet, dass** die Gegenelektrode (70) eine Teilgegenelektrode (71) und eine weitere Teilgegenelektrode (72) aufweist, die von der Teilgegenelektrode (71) elektrisch isoliert und mit dieser ineinandergreifend gebildet ist, und dass jeweils die Teilelektrode (64) und die weitere Teilelektrode (65) sowie die Teilgegenelektrode (71) und die weitere Teilgegenelektrode (72) in Blickrichtung auf die Bauteilfläche (5) einander gegenüberliegend angeordnet sind.

**3.** Lichtemittierendes Bauteil nach Anspruch 1 oder 2, **dadurch gekennzeichnet, dass** die Teilelektrode (64) und die weitere Teilgegenelektrode (72) jeweils mit zwei unterschiedlichen der mehreren organischen Bereiche (60, 61; 61, 62) in Kontakt ist.

**4.** Lichtemittierendes Bauteil nach Anspruch 3, **dadurch gekennzeichnet, dass** die zwei unterschiedlichen organischen Bereiche (60, 61; 61, 62) Licht unterschiedlicher Farbe emittierend gebildet sind.

**5.** Lichtemittierendes Bauteil nach mindestens einem der vorangehenden Ansprüche, **dadurch gekennzeichnet, dass** die Teilelektrode (64) und die weitere Teilgegenelektrode (72) in Blickrichtung auf die Bauteilfläche (5) innerhalb des lichtemittierenden Bereiches (4) zumindest teilweise überlappend gebildet sind.

**6.** Lichtemittierendes Bauteil nach mindestens einem der vorangehenden Ansprüche, **dadurch gekennzeichnet, dass** die weitere Teilelektrode (65) und die Teilgegenelektrode (71) jeweils mit genau einem der organischen Bereiche (62; 60) in Kontakt sind.

**7.** Lichtemittierendes Bauteil nach Anspruch 3 und Anspruch 6, **dadurch gekennzeichnet, dass** der genau eine organische Bereich (62; 60) Licht emittiert, welches verschieden von dem Licht ist, das von den zwei unterschiedlichen organischen Bereiche (60, 61; 61, 62) emittiert wird.

**8.** Lichtemittierendes Bauteil nach mindestens einem der vorangehenden Ansprüche, **dadurch gekennzeichnet, dass** bei der Elektrode (63) Elektrodenabschnitte (66) der Teilelektrode (64) und Elektrodenabschnitte (67) der weiteren Teilelektrode (65) in Blickrichtung auf die Bauteilfläche (5) auf Lücke versetzt angeordnet sind.

**9.** Lichtemittierendes Bauteil nach mindestens einem der Ansprüche 2 bis 8, **dadurch gekennzeichnet, dass** bei der Gegenelektrode (70) Elektrodenabschnitte (74) der Teilgegenelektrode (71) und Elektrodenabschnitte (73) der weiteren Teilgegenelektrode (72) in Blickrichtung auf die Bauteilfläche (5) auf Lücke versetzt zueinander angeordnet sind.

**10.** Lichtemittierendes Bauteil nach mindestens einem der vorangehenden Ansprüche, **dadurch gekennzeichnet, dass** die Elektrode (1, 2; 63) und / oder die Gegenelektrode (70) streifenförmige Elektrodenabschnitte (7, 8; 66, 67; 73, 74) aufweist.

**11.** Lichtemittierendes Bauteil nach mindestens einem der vorangehenden Ansprüche, **dadurch gekennzeichnet, dass** die Elektrode (1, 2; 63) und / oder die Gegenelektrode (6; 70) jeweils in einer einzigen Schicht gebildet sind.

**12.** Lichtemittierendes Bauteil nach mindestens einem der Ansprüche 1 bis 10, **dadurch gekennzeichnet, dass** die Elektrode (1, 2; 63) und / oder die Gegenelektrode (70) über mehrere Schichten verteilt sind.

**13.** Lichtemittierendes Bauteil nach mindestens einem der vorangehenden Ansprüche, **dadurch gekennzeichnet, dass** die Elektrode (1, 2; 63) und / oder die Gegenelektrode (70) innerhalb des lichtemittierenden Bereiches (4) im wesentlichen vollständig überlappend mit den organischen Bereichen (60, 61, 62) gebildet sind.

**14.** Lichtemittierendes Bauteil nach mindestens einem der vorangehenden Ansprüche, **dadurch gekennzeichnet, dass** die Teilelektrode (1; 64) und die weitere Teilelektrode (2; 65) sowie die Teilgegenelektrode (71) und die weitere Teilgegenelektrode (72) kammartig ineinander greifen.

**15.** Lichtemittierendes Bauteil nach mindestens einem der vorangehenden Ansprüche, **dadurch gekennzeichnet, dass** die mehreren organischen Bereiche (60, 61, 62) in Summe ein Weißlichtemissionsspektrum aufweisen.
